Europäisches Patentamt

European Patent Office

Office européen des brevets

(19)

(11) **EP 1 496 545 A1**

(12) **EUROPEAN PATENT APPLICATION**
published in accordance with Art. 158(3) EPC

(43) Date of publication:
**12.01.2005 Bulletin 2005/02**

(51) Int Cl.7: **H01L 21/304**, B08B 3/08,
H01L 21/30, H01L 21/027,
G03F 7/42

(21) Application number: **03746487.2**

(22) Date of filing: **15.04.2003**

(86) International application number:
**PCT/JP2003/004751**

(87) International publication number:
**WO 2003/088337 (23.10.2003 Gazette 2003/43)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **16.04.2002 JP 2002113550**

(71) Applicant: **Sipec Corporation
Bunkyo-ku, Tokyo 112-0012 (JP)**

(72) Inventors:
• **ENDO, Tamio, SIPEC CORPORATION,7th Floor
Bunkyo-ku,To kyo 112-0012 (JP)**

• **SATO, Atsushi, SIPEC CORPORATION,7th Floor
Bunkyo-ku, Tokyo 112-0012 (JP)**
• **AMANO, Yasuhiko,
SIPEC CORPORATION,7th Floor
Bunkyo-ku, Tokyo 112-0012 (JP)**
• **TAMURA,T.,
MITSUI ENGINEERING & SHIPBUILDING CO.
Tamano-shi, Okayama 7o6-8651 (JP)**

(74) Representative: **VOSSIUS & PARTNER
Siebertstrasse 4
81675 München (DE)**

(54) **RESIST REMOVING APPARATUS AND METHOD OF REMOVING RESIST**

(57)    In a resist removing apparatus of the present invention, a distance between a surface of a substrate (10) and an ultraviolet rays transmission plate (3) is adjusted to a predetermined distance by an upward and downward moving mechanism (2b) of a substrate stage (2), and $O_3$ water is supplied from an $O_3$ water supply section (12) to a treatment space formed between the surface of the substrate (10) and the ultraviolet ray transmission plate (3) to form a liquid film (41). Various kinds of active oxygen are generated by emitting ultraviolet rays of wavelengths of 172 nm to 310 nm to the liquid film (41) by an ultraviolet lamp, and dissolving $O_3$, and thereby the resist is dissolved and removed. This construction makes it possible to form the liquid film on the resist and dissolve and remove the resist by using the active oxygen generated in the liquid film, and achieve a breakaway from the resources and energy-intensive technique, namely, realization of an environmentally compatible technique which does not depend on high energy and chemical solvents for removing a resist.

FIG. 1

UV EMISSION CHAMBER FLOW DIAGRAM

**Description**

Technical Field

The present invention relates to a resist removing apparatus and a method of removing a resist, which are indispensable in a lithography process for forming a microstructure such as a semiconductor integrated circuit.

Background Art

At present, as a method of removing a resist film, there are a method of removing a resist film by oxygen plasma ashing, a method of dissolving a resist film by heating by using an organic solvent (phenolic, halogenous or other organic solvent, 90°C to 130°C), and a heating and dissolving method using concentrated sulfuric acid/hydrogen peroxide. All of these methods need time, energy and chemical materials to decompose and dissolve the resist film, which becomes a burden on the lithography process. Though the demand for a new resist removing technique which replaces the removal by ashing and dissolving like this grows sharply, there are a small number of developments of the removal technique. A typical example of this is a new technique which develops a removing liquid and uses the removing action of a high-frequency supersonic wave. As the removing liquid, the removing effect of, for example, "IPA-$H_2O_2$ component + salt such as fluoride" is recognized.

An object of the present invention is to provide a resist removing apparatus and a method of removing a resist which make it possible to form a liquid film on a resist and dissolve and remove the resist by using active oxygen generated in the liquid film, and achieve a breakaway from a resource and energy intensive type technique, namely, realization of an environmentally compatible type technique which does not depend on high energy and chemical solvents for removing a resist.

Summary of the Invention

A resist removing apparatus of the present invention includes a treatment chamber constituting a treatment space for removing a resist on a substrate, a substrate supporter supporting the substrate in the aforesaid treatment chamber and having a mechanism for moving the substrate in an upward and downward direction in the aforesaid treatment chamber and freely adjusting the treatment space, and a liquid film generator for forming a liquid film containing active oxygen on the resist of the substrate, and on forming the liquid film, the treatment space is adjusted by the moving mechanism of the aforesaid substrate supporter to control a state of the liquid film.

In one mode of the resist removing apparatus of the present invention, the aforesaid liquid film generator includes an ultraviolet rays emitting mechanism for emitting ultraviolet rays to the liquid film formed on the substrate.

In one mode of the resist removing apparatus of the present invention, wavelengths of the ultraviolet rays emitted from the ultraviolet rays emitting mechanism are 172 nm to 310 nm.

In one mode of the resist removing apparatus of the present invention, the ultraviolet rays emitting mechanism is a low pressure ultraviolet lamp.

In one mode of the resist removing apparatus of the present invention, a surface of the substrate and an upper surface portion of an inside of the aforesaid treatment chamber are brought into close vicinity to each other by the moving mechanism of the aforesaid substrate supporter, and the state of the liquid film is adjusted to a size to cover an approximately entire surface of the resist on the substrate.

In one mode of the resist removing apparatus of the present invention, a distance between the surface of the substrate and the upper surface portion of the inside of the treatment chamber is 1 mm or less.

In one mode of the resist removing apparatus of the present invention, the aforesaid liquid film generator includes an ozone supply mechanism for supplying ozone water to the liquid film.

In one mode of the resist removing apparatus of the present invention, the aforesaid liquid film generator includes peroxide water supply mechanism for supplying peroxide water to the liquid film.

In one mode of the resist removing apparatus of the present invention, the surface of the substrate and the upper surface portion of the inside of the aforesaid treatment chamber are separated from each other by the moving mechanism of the aforesaid substrate supporter, and the state of the liquid film is adjusted so that condensation forms on the resist surface on the substrate as liquid drops.

In one mode of the resist removing apparatus of the present invention, the aforesaid liquid film generator includes a mechanism for supplying mist-containing water vapor.

In one mode of the resist removing apparatus of the present invention, the aforesaid liquid film generator includes an ozone supply mechanism for supplying ozone gas to the mist-containing water vapor generated in the mist-containing water vapor supply mechanism to generate the active oxygen inside the liquid film formed on the substrate.

In one mode of the resist removing apparatus of the present invention, the aforesaid liquid film generator has a porous ceramic plate and supplies mist-containing water vapor from holes of the porous ceramic plate.

A method of removing a resist of the present invention includes the steps of performing distance adjustment so that a substrate provided with a resist on a surface thereof and an upper surface portion of an inside of a treatment chamber constituting a treatment space for removing the resist are close to each other, forming a liquid film containing active oxygen to have film thickness restricted to the distance to cover an approximately entire surface of the resist on the substrate and dissolving and removing the resist by an action of the active oxygen.

In one mode of the method of removing the resist of the present invention, the distance between the surface of the substrate and the upper surface portion of the inside of the treatment chamber is adjusted to 1 mm or less.

In one mode of the method of removing the resist of the present invention, generation of the active oxygen is promoted in the liquid film by emitting ultraviolet rays to the liquid film.

In one mode of the method of removing the resist of the present invention, the active oxygen is generated in the liquid film by supplying ozone water to the liquid film.

In one mode of the method of removing the resist of the present invention, the active oxygen is generated in the liquid film by supplying peroxide water to the liquid film.

A method of removing a resist of the present invention includes the steps of performing distance adjustment so that a substrate provided with a resist on a surface thereof and an upper surface portion of an inside of a treatment chamber constituting a treatment space for removing the resist are spaced from each other, supplying mist-containing water vapor containing active oxygen to allow liquid drops to form condensation on a surface of the resist, and dissolving and removing the resist by an action of the active oxygen.

In one mode of the method of removing the resist of the present invention, generation of the active oxygen is promoted in the liquid film by emitting ultraviolet rays to the liquid film.

In one mode of the method of removing the resist of the present invention, the active oxygen is generated in the liquid film by supplying ozone gas to the liquid film.

In one mode of the method of removing the resist of the present invention, the active oxygen is generated in the liquid film by supplying peroxide water to the liquid film.

Brief Description of the Drawings

Fig 1 is a schematic diagram showing a schematic constitution of a resist removing apparatus of a first embodiment;
Fig. 2 is a schematic diagram showing a substrate surface and its vicinity in the resist removing apparatus of the first embodiment;
Fig. 3 is a schematic diagram showing a state of a treatment chamber and its vicinity, which is a main constitution of a resist removing apparatus of a second embodiment; and
Fig. 4 is a schematic diagram showing a state of a treatment chamber and its vicinity, which is a main constitution of a resist removing apparatus of a modification example of the second embodiment.

Detailed Description of the Preferred Embodiments

Preferred embodiments to which the present invention is applied will be explained in detail with reference to the drawings, hereinafter.

-First Embodiment-

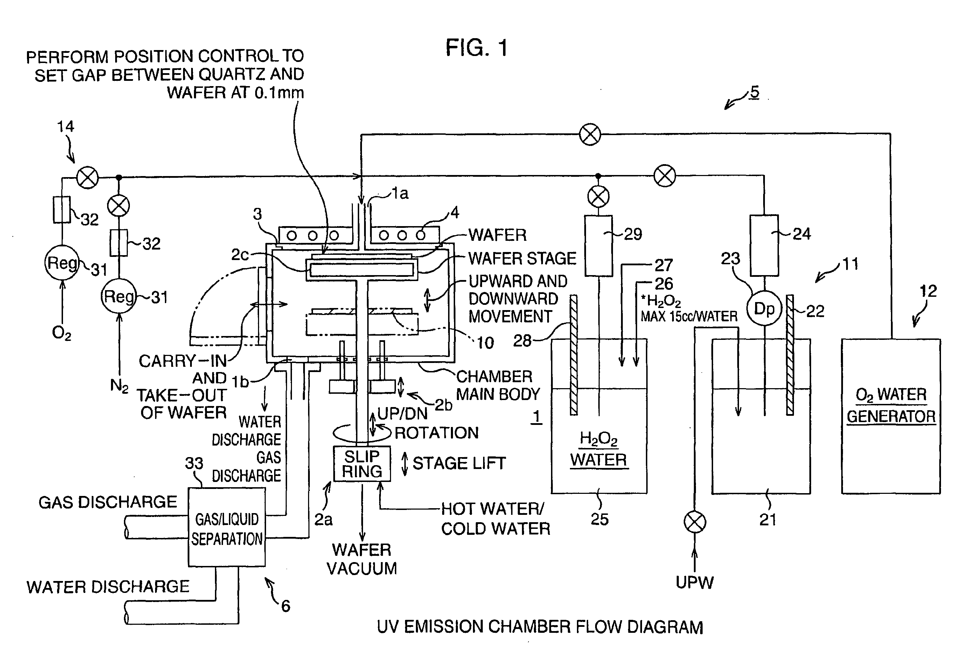

Fig. 1 is a schematic diagram showing a schematic constitution of a resist removing apparatus of a first embodiment.

This resist removing apparatus is for removing a resist formed on a substrate 10 such as a silicon wafer or a glass substrate in a lithography process, and is constructed by including a single sheet treatment chamber 1, which is a treatment chamber constructing a treatment space for removing the resist on the substrate 10, and which the substrate can be carried in and taken from, a substrate stage 2 which is provided in the treatment chamber 1 and on which the substrate 10 is supported and fixed, an ultraviolet ray transmission plate 3 provided on an upper surface portion of the treatment chamber 1 and made of a synthetic quartz glass, a low pressure ultraviolet lamp 4 provided on an upper portion of the ultraviolet ray transmission plate 3 and emitting ultraviolet rays into the treatment chamber 1 via the ultraviolet ray transmission plate 3, a liquid film generator 5 for supplying ultra pure water and various kinds of chemical liquids via an inflow port 1a of the treatment chamber 1, and a liquid/gas discharger 6 for discharging a liquid and gas inside the treatment chamber 1 via an outlet port 1b of the treatment chamber 1.

The substrate stage 2 has a temperature regulating mechanism 2c for regulating the temperature of the substrate 10 placed thereon by hot water/cool water, and further has a rotating mechanism 2a for freely rotating the substrate 10 placed thereon and an upward and downward moving mechanism 2b for freely moving the substrate 10 placed as described above in the vertical direction, and at a time of removing a resist on the substrate 10, a surface of the substrate 10 and the ultraviolet ray transmission plate 3 are made closer to each other at a predetermined distance therebetween by the operation of the upward and downward moving mechanism 2b as will be described later.

The liquid film generator 5 is constructed by including an ultra pure water supply section 11 for supplying ultra pure water into the treatment chamber 1, an $O_3$ water supply section 12 for generating and supplying ozone water ($O_3$ water), an $H_2O_2$ water supply section 13 for generating and supplying an aqueous solution of

hydrogen peroxide ($H_2O_2$ water), and an $O_2/N_2$ gas supply section 14 for supplying an $O_2/N_2$ gas to the surface of the substrate 10 to facilitate ejection of the substrate 10 by removing the chemical liquid remaining on the surface of the substrate 10 after resist removing treatment.

The ultra pure water supply section 11 is constructed by including an ultra pure water tank 21 for storing ultra pure water supplied from outside, a level gauge 22 for measuring the level of the stored ultra pure water, a diaphragm pump 23 for accurately sucking and feeding out a predetermined amount of ultra pure water periodically, for example, and a flow meter 24 for measuring the amount of the ultra pure water fed out by the diaphragm pump 23.

The $H_2O_2$ water supply section 13 is constructed by including a pumping tank 25 for storing $H_2O_2$ water, an $H_2O_2$ supply line 26 for supplying $H_2O_2$ to the ultra pure water to generate $H_2O_2$ water, a pumping mechanism 27 for supplying $N_2$ into the pumping tank 25 to pump a predetermined amount of $H_2O_2$ water from the pumping tank 25, a level gauge 28 for measuring the level of the stored $H_2O_2$ water, and a flow control valve 29 for controlling an amount of $H_2O_2$ water which is fed out.

The $O_2/N_2$ gas supply section 14 forms passages for $O_2$ gas and $N_2$ gas respectively, and is provided with a passage for a mixture gas of both of them, and each of the passages for the $O_2$ gas and the $N_2$ gas is provided with a pressure regulator 31 and a mass flow controller 32 for regulating the flow of the gas.

The liquid/gas discharger 6 has a gas-liquid separating mechanism 33, and the discharged liquid and the discharged gas are separated by the operation of this liquid-gas separating mechanism 33.

In order to remove the resist on the substrate 10 by using this resist removing apparatus, a distance between the surface of the substrate 10 and the ultraviolet ray transmission plate 3 is adjusted to a predetermined distance by the upward and downward moving mechanism 2b of the substrate stage 2. As this distance, 0.1 mm to 1mm is preferable in consideration that the distance should be within the range in which the ultraviolet rays emitted as will be described later are not attenuated.

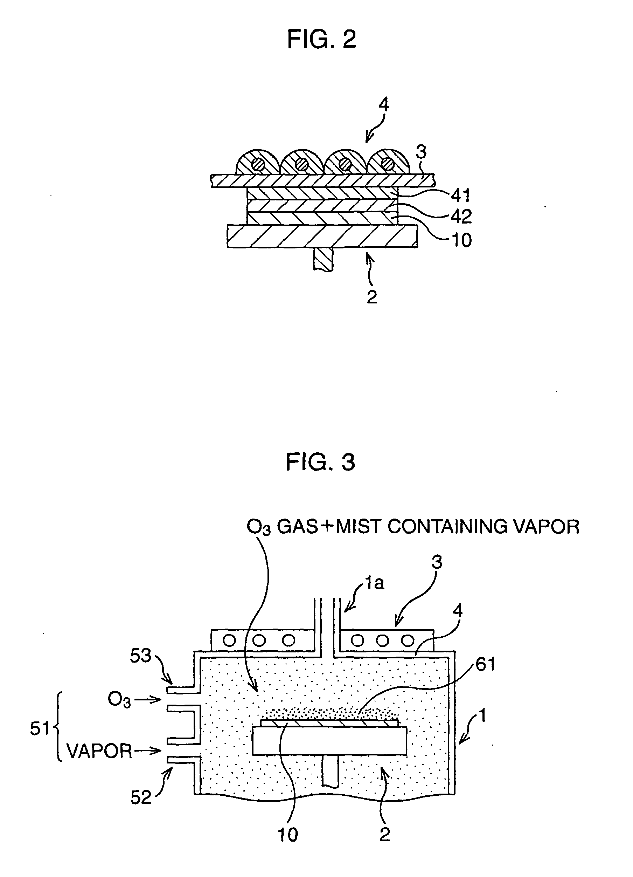

While the substrate 10 is being rotated by the rotating mechanism 2a of the substrate stage 2 in this state, $O_3$ water is supplied into the treatment space formed between the surface of the substrate 10 of the treatment chamber 1 and the ultraviolet ray transmission plate 3 from the $O_3$ water supply section 12. Thereby, the treatment space is filled with the $O_3$ water, and a liquid film 41, which is formed to have the film thickness restricted within a thin film state of the distance (0.1 mm to 1 mm) of the surface of the substrate 10 and the ultraviolet ray transmission plate 3 and covers an approximately entire surface of a resist 42 on the substrate 10, is formed, as shown in Fig. 2.

In the $O_3$ water of the liquid film 41, as a result of dissolution of $O_3$ into aqueous solution, $O_3$ is decomposed by the reaction of $OH^-$ and $O_3$, and various kinds of active oxygen such as $HO_2$, $O_2^-$, and $OH$ are generated, as shown in the following series of (Formula 1).

(Formula 1):

$$O_3 + OH^- \rightarrow HO_2 + O_2^-$$

$$O_3 + HO_2 \rightarrow 2O_2 + OH$$

$$O_3 + OH \rightarrow O_2 + HO_2$$

$$2HO_2 \rightarrow O_3 + H_2O$$

$$HO_2 + OH \rightarrow O_2 + H_2O$$

Accordingly, in addition to the direct oxidation by $O_3$, radical oxidation by active oxygen such as $O_2^-$, $HO_2$ and $OH$, which are secondarily generated, advances in the aqueous water (in this case, selectivity other than $O_3$ reduces, but oxidation is intense).

Subsequently, in the state in which the liquid film 41 is formed, ultraviolet rays are uniformly emitted to the liquid film 41 by the ultraviolet lamp 4. At this time, $O_3$ is decomposed by the ultraviolet rays, and by the reaction of excited oxygen atoms generated thereby and molecules of water, generation of hydroxy radical (OH) is promoted, as shown in the following series of (Formula 2). In this case, as the wavelength of the ultraviolet rays which are emitted, it is required to be 310 nm or less to decompose $O_3$, and 50% transmission distance of the ultraviolet rays with the wavelength of 172 nm with respect to air is 3.1 mm from the optical absorption sectional area of oxygen ($0.259 \times 10^{-18}$ the number of molecules / $cm^2$), but since it is difficult to make the apparatus with the 50% transmission distance of 3.1 mm or less, it is preferable to use the ultraviolet rays with the wavelength of 172 nm to 310 nm. In this embodiment, the ultraviolet rays with the comparatively short wavelength of around 184.9 nm are adopted. Here, the ultraviolet rays are used to generate $O_3$ in the aqueous water and cause the reaction to decompose the generated $O_3$, and therefore their wavelengths may be in the comparatively wide range as described above.

(Formula 2):

$$O_3 + h\nu(\lambda<310\ nm) \rightarrow O(^1D) + O_2(a^1\Delta P)$$

$$H_2O + O(^1D) \rightarrow 2OH$$

$$OH + O_3 \rightarrow O_2 + HO_2$$

$$HO_2 + O_3 \rightarrow 2O_2 + OH$$

As described above, the resist that is an organic substance is decomposed into $H_2O/CO_2$ by the activating action, which various kinds of active oxygen generated in the liquid film 41 as described above have, and dissolved and removed.

At the time of generating the liquid film 41, $H_2O_2$ water may be supplied from the $H_2O_2$ water supply section 13 in place of the $O_3$ water, or with the $O_3$ water. In this case, as shown in the following series of (Formula 3), $H_2O_2$ reacts with $O_3$, and thereby the generation of the hydroxy radical (OH) is promoted.

$$\text{(Formula 3):}$$

$$H_2O_2 \rightarrow H + HO_2^-$$

$$HO_2^- + O_3 \rightarrow OH + O_2^- + O_2$$

Further, by emitting the aforesaid ultraviolet rays to the liquid film 41 containing $H_2O_2$ water, $H_2O_2$ is directly decomposed, and generation of hydroxy radical (OH) is further promoted, as shown in the following (Formula 4).

$$\text{(Formula 4):}$$

$$H_2O_2 + h\nu \ (\lambda < 310 \text{ nm}) \rightarrow 2OH$$

As described thus far, according to this embodiment, it is made possible to form the liquid film 41 on the resist on the substrate 1, and dissolve and remove the resist by using various kinds of active oxygen generated in the liquid film 41, and a breakaway from a resource and energy-intensive technique, namely, realization of an environmentally compatible technique which does not depend on high energy and chemical solvents for removing a resist can be achieved.

-Second Embodiment-

In this embodiment, a resist removing apparatus including a treatment chamber and a substrate stage which are constructed approximately similarly to the first embodiment is disclosed, but this embodiment differs from the first embodiment in the point that the state of the supplied liquid film on the resist is different. The common components and the like to the first embodiment are given the same reference numerals and symbols, and the explanation thereof will be omitted.

Fig. 3 is a schematic diagram showing a state of the treatment chamber and its vicinity, which is a main constitution of the resist apparatus of the second embodiment.

This resist removing apparatus is constructed by including a treatment chamber 1 provided with an ultraviolet ray transmission plate 3, an ultraviolet lamp 4 and the like similarly to the resist removing apparatus of the first embodiment, a substrate stage 2 having an upward and downward moving mechanism 2b, a liquid film generator 51, liquid/gas discharger (not shown: the same as the liquid/gas discharger 6) which performs liquid discharge and gas discharge inside the treatment chamber 1 via an outlet port of the treatment chamber 1.

Here, the liquid film generator 51 is constructed by including a vapor supply section 52 for supplying water vapor into the treatment chamber 1, and an $O_3$ gas supply section (ozonizer) 53 for supplying $O_3$ gas of high concentration into the treatment chamber 1.

In order to remove the resist on a substrate 10 by using this resist removing apparatus, a distance between a surface of the substrate 10 and the ultraviolet ray transmission plate 3 is initially adjusted to a predetermined distance by the upward and downward moving mechanism 2b of the substrate stage 2. In this embodiment, the distance is made longer as compared with the first embodiment (10 mm to 30 mm). Here, the temperature in the treatment chamber 1 is adjusted to 80°C to 90°C, and the substrate temperature is adjusted to room temperature to 60°C.

While the substrate 10 is being rotated by the rotating mechanism 2a of the substrate stage 2 in this state, vapor is supplied from the vapor supply section 52 and $O_3$ gas is supplied from the $O_3$ gas supply section 53, respectively into the treatment space formed between the front surface of the substrate 10 of the treatment chamber 1 and the ultraviolet ray transmission plate 3. At this time, the aforesaid vapor is the vapor containing mist, and the inside of the treatment chamber 1 is in the atmosphere of the mixture of mist-containing vapor in a saturated vapor state and $O_3$ gas. The mist-containing vapor is the mixture of the mist of a grain size of 10 μm to 50 μm and vapor. Since the mist has a large surface area due to its approximately spherical shape and hence $O_3$ gas easily penetrates into it, the $O_3$ gas can be sufficiently supplied by using this mist-containing vapor.

Due to the aforesaid saturated mixture atmosphere in addition to the temperature difference between the temperature of the treatment camber 1 and the substrate temperature, liquid drops form condensation on the resist of the substrate 10 as a number of microscopic thin liquid films 61 into which $O_3$ gas is dissolved. At this time, in the liquid film 61, the series of reactions of (Formula 1) explained in the first embodiment are caused, $O_3$ is decomposed by the reaction of OH⁻ and $O_3$ by dissolution of $O_3$ into aqueous water, and various kinds of active oxygen such as $HO_2$, $O_2^-$ and OH are generated.

Accordingly, in the aqueous water, radical oxidation by the active oxygen such as $O_2^-$, $HO_2$ and OH, which are secondarily generated, advances in addition to the direct oxidation by $O_3$.

Subsequently, in the state in which the liquid films 61 are formed, ultraviolet rays are uniformly emitted to the liquid films 61 by the ultraviolet lamp 4 under the same conditions as in the first embodiment. At this time, the series of reactions of (Formula 2) explained in the first embodiment is caused, $O_3$ is decomposed by the ultraviolet rays, and by the reaction of the excited oxygen atoms generated by this and molecules of water, generation of hydroxy radical (OH) is promoted.

By the activating action, which various kinds of active oxygen generated in the liquid films 61 as described above have, the resist that is an organic substance is decomposed into $H_2O$ and $CO_2$, and dissolved and removed.

As explained thus far, according to this embodiment, it is made possible to form the liquid films 61 on the resist on the substrate 10, and dissolve and remove the resist by using various kinds of active oxygen generated in the liquid films 61 (especially, in their surface layers), and a breakaway from the resource and energy-intensive technology, namely, realization of an environmentally compatible technology that does not depend on high energy or chemical solvents for removing a resist can be achieved.

-Modification Example-

Here, a modification example of the second embodiment will be explained.

In this modification example, a resist removing apparatus constructed approximately similarly to the second embodiment is disclosed, but the modification example differs in the point that a porous ceramic plate is provided in place of the ultraviolet lamp.

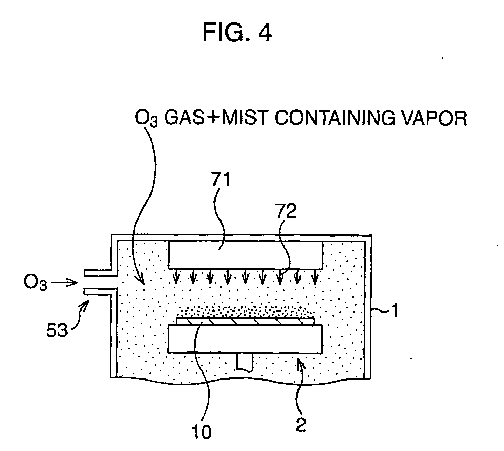

Fig. 4 is a schematic diagram showing a state of a treatment chamber and its vicinity, which is a main constitution of the resist removing apparatus of this modification example.

This resist removing apparatus is constructed by including a treatment chamber 1 similar to the resist removing apparatus of the first embodiment, a porous ceramic plate 71 provided in place of the ultraviolet lamp, a substrate stage 2 having an upward and downward moving mechanism 2b, a high concentration $O_3$ gas supply section 53, and a liquid/gas discharger (not shown: the same as the liquid/gas discharger 6) which performs liquid discharge and gas discharge inside the treatment chamber 1 via an outlet port of the treatment chamber 1.

The porous ceramic plate 71 is constructed so that mist-containing water vapor containing uniform mists of a small grain size and mist-containing water vapor containing $O_3$ gas are supplied to the substrate 10 via holes 72.

In order to remove the resist on the substrate 10 by using this resist removing apparatus, the distance between the front surface of the substrate 10 and the porous ceramic plate 71 is firstly adjusted to a predetermined distance by the upward and downward moving mechanism 2b of the substrate stage 2. In this example, the distance is made longer (10 mm to 30 mm) as compared with the first embodiment. Here, the temperature inside the treatment chamber 1 is adjusted to 80°C to 90°C, and the substrate temperature is adjusted to room temperature to 60°C.

While the substrate 10 is being rotated by the rotating mechanism 2a of the substrate stage 2 in this state, vapor is supplied from the holes 72 of the porous ceramic plate 71, and $O_3$ gas is supplied from the high concentration $O_3$ gas supply section 53, respectively into the treatment space formed between the surface of the substrate 10 of the treatment chamber 1 and the porous ceramic plate 71. At this time, the aforesaid vapor is mist-containing water vapor, the inside of the treatment chamber 1 is in the atmosphere of the mixture of the mist-containing water vapor in a saturated vapor state and $O_3$ gas, and $O_3$ gas is dissolved into the mist-containing water vapor.

Due to the aforesaid saturated mixture atmosphere in addition to the temperature difference between the temperature of the inside of the treatment chamber 1 and the substrate temperature, the liquid drops form condensation on the resist of the substrate 10 as a number of microscopic thin liquid films 61.

Accordingly, in the aqueous solution, radical oxidation by the active oxygen such as $O_2^-$, $HO_2$ and OH, which are secondarily generated, advances in addition to the direct oxidation by $O_3$.

By the activating action, which various kinds of active oxygen generated in the liquid films as described above have, the resist that is an organic substance is decomposed into $H_2O$ and $CO_2$, and dissolved and removed.

As explained thus far, according to this modification example, the liquid drops into which $O_3$ is dissolved form condensation to form the liquid films on the resist, whereby it is made possible to dissolve and remove the resist by using various kinds of active oxygen, and it is possible to achieve a breakaway from the resource and energy-intensive technology, namely, realization of an environmentally compatible technology that does not depend on high energy or chemical solvents for removing a resist.

Industrial Applicability

According to the present invention, it is made possible to form the liquid films on the resist and dissolve and remove the resist by using active oxygen generated in the liquid films to thereby enable a breakaway from resource and energy-intensive technology, namely, realization of an environmentally compatible technology that does not depend on high energy or chemical solvents for removing a resist.

**Claims**

**1.** A resist removing apparatus, comprising:

a treatment chamber constituting a treatment space for removing a resist on a substrate;

a substrate supporter supporting the substrate in said treatment chamber and having a mechanism for moving the substrate in an upward and downward direction in said treatment chamber and freely adjusting the treatment space; and

a liquid film generator for forming a liquid film containing active oxygen on the resist of the substrate,

wherein on forming the liquid film, the treatment space is adjusted by the moving mechanism of said substrate supporter to control a state of the liquid film.

2. The resist removing apparatus according to claim 1, wherein said liquid film generator includes an ultraviolet ray emitting mechanism for emitting ultraviolet rays to the liquid film formed on the substrate.

3. The resist removing apparatus according to claim 2, wherein wavelengths of the ultraviolet rays emitted from the ultraviolet ray emitting mechanism are 172 nm to 310 nm.

4. The resist removing apparatus according to claim 2, wherein the ultraviolet ray emitting mechanism is a low pressure ultraviolet lamp.

5. The resist removing apparatus according to claim 2, wherein a surface of the substrate and an upper surface portion of an inside of said treatment chamber are brought into close vicinity to each other by the moving mechanism of said substrate supporter, and the state of the liquid film is adjusted to a size to cover an approximately entire surface of the resist on the substrate.

6. The resist removing apparatus according to claim 5, wherein a distance between the surface of the substrate and the upper surface portion of the inside of said treatment chamber is 1 mm or less.

7. The resist removing apparatus according to claim 6, wherein said liquid film generator includes an ozone supply mechanism for supplying ozone water to the liquid film.

8. The resist removing apparatus according to claim 6, wherein said liquid film generator includes a peroxide water supply mechanism for supplying peroxide water to the liquid film.

9. The resist removing apparatus according to claim 2, wherein the surface of the substrate and the upper surface portion of the inside of said treatment chamber are separated from each other by the moving mechanism of said substrate supporter, and the state of the liquid film is adjusted so that condensation forms on the resist surface on the substrate as liquid drops.

10. The resist removing apparatus according to claim 9, wherein said liquid film generator includes a mechanism for supplying mist containing water vapor.

11. The resist removing apparatus according to claim 10, wherein said liquid film generator includes an ozone supply mechanism for supplying ozone gas to the mist containing water vapor generated in the mist containing water vapor supply mechanism to generate the active oxygen inside the liquid film formed on the substrate.

12. The resist removing apparatus according to claim 1, wherein said liquid film generator has a porous ceramic plate and supplies mist containing water vapor from holes of the porous ceramic plate.

13. A method of removing a resist, comprising the steps of:

performing distance adjustment so that a substrate provided with a resist on a surface and an upper surface portion of an inside of a treatment chamber constituting a treatment space for removing the resist are close to each other;

forming a liquid film containing active oxygen to have film thickness restricted to the distance to cover an approximately entire surface of the resist on the substrate;, and

dissolving and removing the resist by an action of the active oxygen.

14. The method of removing the resist according to claim 13, wherein the distance between the surface of the substrate and the upper surface portion of the inside of the treatment chamber is adjusted to 1 mm or less.

15. The method of removing the resist according to claim 13, wherein generation of the active oxygen is promoted in the liquid film by emitting ultraviolet rays to the liquid film.

16. The method of removing the resist according to claim 13, wherein the active oxygen is generated in the liquid film by supplying ozone water to the liquid film.

17. The method of removing the resist according to claim 13, wherein the active oxygen is generated in the liquid film by supplying peroxide water to the liquid film.

18. A method of removing a resist, comprising the steps of:

    performing distance adjustment so that a substrate provided with a resist on a surface and an upper surface portion of an inside of a treatment chamber constituting a treatment space for removing the resist are spaced from each other;
    supplying mist containing water vapor containing active oxygen to allow liquid drops to form condensation on a surface of the resist; and
    dissolving and removing the resist by an action of the active oxygen.

19. The method of removing the resist according to claim 18, wherein generation of the active oxygen is promoted in the liquid film by emitting ultraviolet rays to the liquid film.

20. The method of removing the resist according to claim 18, wherein the active oxygen is generated in the liquid film by supplying ozone gas to the liquid film.

21. The method of removing the resist according to claim 18, wherein the active oxygen is generated in the liquid film by supplying peroxide water to the liquid film.

FIG. 1

UV EMISSION CHAMBER FLOW DIAGRAM

## FIG. 2

## FIG. 3

O₃ GAS+MIST CONTAINING VAPOR

## FIG. 4

O$_3$ GAS+MIST CONTAINING VAPOR

## INTERNATIONAL SEARCH REPORT

| | International application No. |
|---|---|
| | PCT/JP03/04751 |

A. CLASSIFICATION OF SUBJECT MATTER
   Int.Cl$^7$ H01L21/304, B08B3/08, H01L21/30, H01L21/027, G03F7/42

According to International Patent Classification (IPC) or to both national classification and IPC

B. FIELDS SEARCHED

*Minimum documentation searched (classification system followed by classification symbols)*
   Int.Cl$^7$ H01L21/304, B08B3/08, H01L21/30, H01L21/027, G03F7/42

*Documentation searched other than minimum documentation to the extent that such documents are included in the fields searched*

| | | | |
|---|---|---|---|
| Jitsuyo Shinan Koho | 1926-1996 | Toroku Jitsuyo Shinan Koho | 1994-2003 |
| Kokai Jitsuyo Shinan Koho | 1971-2003 | Jitsuyo Shinan Toroku Koho | 1996-2003 |

*Electronic data base consulted during the international search (name of data base and, where practicable, search terms used)*

C. DOCUMENTS CONSIDERED TO BE RELEVANT

| Category* | Citation of document, with indication, where appropriate, of the relevant passages | Relevant to claim No. |
|---|---|---|
| A | JP 2002-25971 A   (Seiko Epson Corp.), 25 January, 2002 (25.01.02), (Family: none) | 1-21 |
| A | EP 1088603 A1   (PUREX CO., LTD.), 04 April, 2001 (04.04.01), & JP 2001-340817 A | 1-21 |
| A | JP 2001-15472 A   (Hoya Shotto Kabushiki Kaisha), 19 January, 2001 (19.01.01), (Family: none) | 1-21 |
| A | JP 63-33824 A   (Dainippon Screen Mfg. Co., Ltd.), 13 February, 1988 (13.02.88), (Family: none) | 1-21 |

☐ Further documents are listed in the continuation of Box C.    ☐ See patent family annex.

| | |
|---|---|
| * Special categories of cited documents: <br> "A" document defining the general state of the art which is not considered to be of particular relevance <br> "E" earlier document but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| 07 July, 2003 (07.07.03) | 22 July, 2003 (22.07.03) |

| Name and mailing address of the ISA/ <br> Japanese Patent Office | Authorized officer |
|---|---|
| Facsimile No. | Telephone No. |

Form PCT/ISA/210 (second sheet) (July 1998)